# EUROPEAN PATENT APPLICATION

(11) **EP 4 482 029 A1**
(43) Date of publication of application: **25.12.2024**
(21) Application number: 24178230.9
(22) Date of filing: 27.05.2024
(51) Int. Cl.: H03F 1/34, H03F 3/187, H03F 3/217, H03M 1/66, H03M 3/00

(54) **AUDIO AMPLIFICATION METHOD AND DEVICE**

(30) Priority: 21.06.2023 IT 202300012858
(71) Applicant: STMicroelectronics International N.V., 1228 Plan-les-Ouates, Geneva (CH)
(72) Inventor: BOTTI, Edoardo, I-29029 Vigevano (Pavia) (IT); STILGENBAUER, Francesco, I-20017 Rho (Milano) (IT); DE FERRARI, Matteo, I-28040 Oleggio Castello (Novara) (IT); BONIZZONI, Edoardo, I-27100 Pavia (IT); MALCOVATI, Piero, I-27100 Pavia (IT)
(74) Representative: Buzzi, Notaro & Antonielli d'Oulx S.p.A.

(57) **Abstract**

A method, comprising: receiving a digital input audio signal (D); applying signal processing (21, 22, 24, 26) to the digital input audio signal (D) received; providing an analog audio output signal (V_{OUT}) based on the digital input audio signal (D) via a switching converter circuit (17) driven by a pulse-width-modulated, PWM, signal (DRV), and sensing (19, R_{FB}) the analog audio output signal (V_{OUT}) and providing an analog feedback signal (I_{FB}) indicative of the sensed analog audio output signal (V_{OUT}). Applying signal processing (21, 22, 24, 26) to the digital input audio signal (D) comprises: producing (21) a digital error signal (D_{ERR}) indicative of a difference between the digital input audio signal (D) and a digital word signal (W); applying digital-to-analog conversion, DAC (22) to the digital error signal (D_{ERR}), producing an analog replica of the digital error signal (I_{ERR}) as a result; producing (24) an analog difference signal (I_{DIFF}) indicative of a difference between the analog replica of the digital error signal (I_{ERR}) and the analog feedback signal (I_{FB}); applying analog-to-digital conversion (26) to the analog difference signal (I_{DIFF}), producing said digital word signal (W) as a result; applying digital filtering (162; 562) to the digital word signal (W), producing a filtered digital word signal (D_{C}) as a result; and driving said switching converter circuit (17) with the PWM signal (DRV) produced based on the filtered digital word signal (Dc) .

## Description

### Technical field

The description relates to methods and devices for amplification of audio signals (briefly, audio amplification).

One or more embodiments may be applied to power audio amplification devices, e.g., for automotive entertainment systems.

### Description of the related art

Thanks to reduced costs of digital signal processing, digital audio signals are becoming common even in the realm of power amplifiers, whose output is inherently of an analog nature in order to drive audio speakers.

Therefore, such power amplifier technologies may comprise a mix of digital and analog components, with noise and distortion performance playing an important role for demanding applications.

Developing power amplifier structures suitable for processing digital input signals is also of interest with the aim of further improve performance at a lower cost.

### Object and summary

An object of one or more embodiments is to contribute in providing such improved solutions.

According to one or more embodiments, that object can be achieved via a method having the features set forth in the claims that follow.

One or more embodiments may relate to a corresponding audio amplification device.

The claims are an integral part of the technical teaching provided herein with reference to the embodiments.

One or more embodiments facilitate reducing the chip size of a power amplifier with a digital input.

One or more embodiments increase the role of digital parts of the circuit with respect to analog blocks.

One or more embodiments reduce the complexity of the circuit architecture of existing solutions.

One or more embodiments facilitate reducing the area footprint and complexity of circuit blocks.

### Brief description of the several views of the drawings

One or more embodiments will now be described, by way of non-limiting example only, with reference to the annexed Figures, wherein:
Figure 1 is a diagram exemplary of an audio amplification device,
Figure 2 is a diagram exemplary of an audio amplification device as per the present disclosure
Figure 3 is a diagram exemplary of a digital-to-analog converter, DAC circuit as per the present disclosure,
Figure 4 is a diagram exemplary of an evolution over time of signals in one or more embodiments,
Figure 5 is a diagram exemplary of an alternative audio amplification device as per the present disclosure.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The drawings are in simplified form and are not to precise scale.

Throughout the figures annexed herein, like parts or elements are indicated with like references/numerals unless the context indicates otherwise, and for brevity a corresponding description will not be repeated for each and every figure.

The references used herein are provided merely for convenience and hence do not define the extent of protection or the scope of the embodiments.

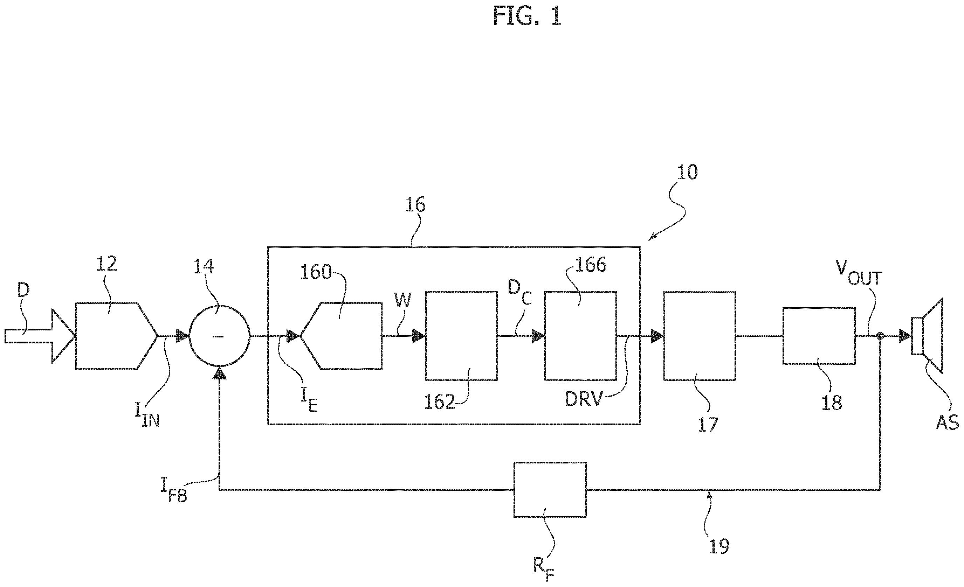

Figure 1 is a diagram of an audio amplification device, such as the audio amplification device which is discussed in Italian patent application no. 102022000018453, not yet published at the date of filing the instant application, for instance.

As exemplified in Figure 1, an audio amplification device (or audio amplifier) 10 for performing audio amplification, comprises:
an input node D configured to receive a digital input signal D;
an output node V_{OUT} configured to provide an output signal V_{OUT} to drive an audio speaker to reproduce an audio signal based on the output signal V_{OUT};
a digital-to-analog converter (briefly, DAC) circuit 12 coupled to the input node D to receive the digital signal D, the DAC circuit 12 configured to apply digital-to-analog conversion to the digital signal D, providing an analog signal I_{IN} as a result (such as an electric current signal I_{IN}, for instance);
a summation node 14 coupled to the DAC circuit 12 and to the output node V_{OUT} (e.g., via a feedback branch 19, comprising the feedback resistive element R_{FB} to provide the feedback signal I_{FB}), the summation node 14 configured to produce an error signal I_{E} (e.g., as an electrical current signal) equal to a difference between the analog signal I_{IN} and the feedback signal I_{FB};
power circuitry 17 comprising at least one switching transistor configured to be driven to provide a switching voltage signal at a switching node SW based on at least one drive signal DRV, in a manner per se known;
an inductor-capacitor network 18, e.g., comprising an inductor L in series with a capacitor C referred to ground, coupled to the switching node SW of the power circuitry 17 and configured to provide the output (e.g., voltage) signal V_{OUT} at the output node V_{OUT};
a signal processing chain 16 coupled to the summation node 14 to receive the error (e.g., current) signal I_{E} and coupled to the power circuitry 17 to provide the output (e.g., voltage) signal V_{OUT}, the signal processing chain 16 configured to provide the at least one drive signal DRV to the power stage 17, the at least one driver signal being based on the error signal I_{E}.

As exemplified in Figure 1, the amplifier 10 is configured to be coupled to at least one audio speaker AS to provide thereto the output signal V_{OUT}, the audio amplifier 10 configured to drive the at least one audio speaker AS to reproduce the audio signal D received at the input node.

For instance, applying signal processing to the digital input audio signal comprises:
applying digital-to-analog conversion, DAC 12 to the digital input audio signal, producing an analog replica of the digital input signal I_{IN} as a result;
producing 14 an analog error signal I_{E} indicative of a difference between the analog replica of the digital input signal and the analog feedback signal;
applying analog-to-digital conversion, ADC 160 to the analog error signal, producing a digital error signal W as a result;
applying digital filtering 162 to the digital error signal, producing a filtered digital error signal D_{C} as a result; and
driving the switching converter circuit with the PWM signal produced based on the filtered digital error signal.

As exemplified herein, an audio amplifier comprises:
a digital input node configured to receive a digital (audio) input signal D;
a signal processing chain 12, 14, 56, 17 coupled to the digital input node to receive the digital input audio signal, the signal processing chain configured to provide an analog output audio signal V_{OUT} based on the digital input audio signal via a switching converter circuit 17 driven by a pulse-width-modulated, PWM, signal DRV;
a sensing circuit branch 19, R_{FB} coupled to the output node to sense the analog audio output signal and configured to provide an analog feedback signal indicative of the sensed analog audio output signal.

For instance, the signal processing chain comprises:
a digital-to-analog, DAC converter circuit 12 configured to apply digital-to-analog, DAC conversion to the digital input audio signal, producing an analog replica of the digital input signal I_{IN} as a result;
a superposition node 14 coupled to the sensing circuit branch to receive the analog feedback signal and coupled to the DAC converter circuit to receive the analog replica of the digital input signal, the superposition node configured to produce an analog error signal I_{E} indicative of a difference between the analog replica of the digital input signal and the analog feedback signal;
an analog-to-digital converter, ADC circuit 160 coupled to the superposition node to receive the analog error signal I_{E} therefrom and configured to apply analog-to-digital conversion, ADC to the analog error signal, producing a digital error signal W as a result;
a digital filter circuit 162 coupled to the ADC circuit to receive the digital error signal and configured to apply digital filtering to the digital error signal, producing a filtered digital error signal D_{C} as a result, and
a pulse-width-modulated, PWM, generator circuit 166 coupled to the digital filter circuit to receive the filtered digital error signal, the PWM generator circuit configured to drive the switching converter circuit with the PWM signal produced based on the filtered digital error signal.

In an exemplary scenario considered, a method as per the present disclosure comprises:
receiving a digital input audio signal D;
applying signal processing 21, 22, 24, 26 to the digital input audio signal D received;
providing an analog audio output signal V_{OUT} based on the digital input audio signal via a switching converter circuit 17 driven by a pulse-width-modulated, PWM, signal DRV, and
sensing 19, R_{FB} the analog audio output signal V_{OUT} and providing an analog feedback signal I_{FB} indicative of the sensed analog audio output signal.

As exemplified in Figure 1, the signal processing chain 16 comprises:
an (e.g., trans-resistance) ADC circuit 160, comprising an analog-to-digital converter configured to receive a current signal and to convert it into a digital word signal W (or digital error signal W), the ADC circuit 160 coupled to the summation node 14 to receive the error current signal I_{E} therefrom, providing the digital word signal W as a result of applying analog-to-digital conversion thereto,
a digital (e.g., loop) filter circuit 162, known per se, coupled to the ADC circuit 160 to receive the digital word signal W therefrom, the digital filter circuit 162 configured to provide a digital control signal D_{C} based on the received digital word signal W,
a digital PWM stage 166 coupled to the digital filter circuit 162, the digital PWM stage 166 configured to provide the at least one control signal DRV to the power stage 17 based on the received digital control signal 16.

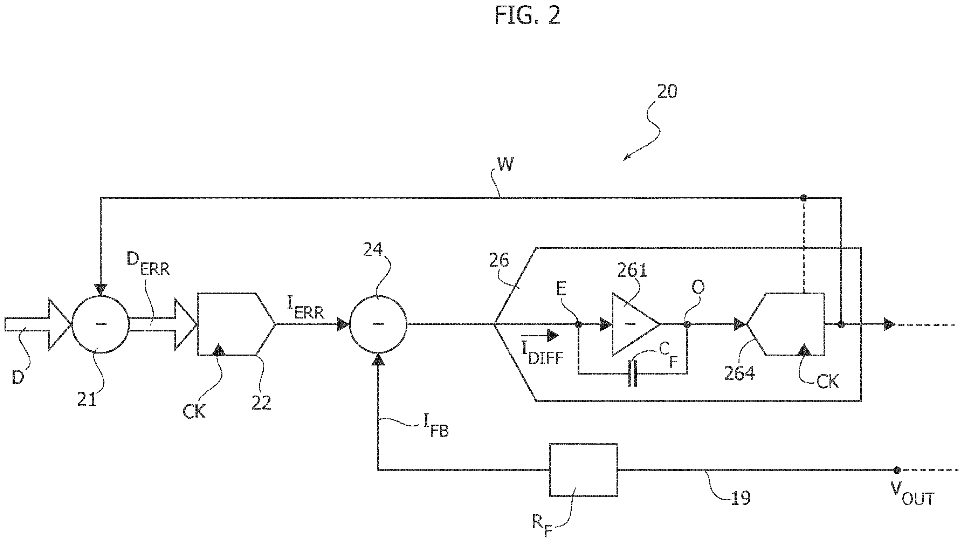

As exemplified in Figure 2, an amplifier device 20 as per the present disclosure comprises:
a first superposition node 21 for digital signals coupled to the digital input node D to receive the digital input signal D therefrom and coupled to an enhanced signal processing circuit block 26 via a digital feedback branch to receive therefrom an ADC converted signal W, the first superposition node 21 configured to subtract the ADC converted signal DRV from the input signal D, producing a digital error signal D_{ERR} as a result;
a digital-to-analog converter (briefly, DAC) circuit 22 coupled to the digital superposition node 21 to receive the digital error signal D_{ERR} therefrom, the DAC circuit 22 configured to apply digital-to-analog conversion processing to the digital error signal D_{ERR}, producing a DAC converted signal I_{ERR} as a result, such as an analog electrical current signal I_{ERR}, for instance;
an second superposition node 24 for analog signals, the second superposition node 24 coupled to the DAC circuit 22 to receive the DAC converted signal I_{ERR} therefrom and coupled to the output node V_OUT of the audio amplification circuit 20 via the feedback branch 19 for analog signals to receive therefrom a feedback signal I_{FB}, such as an analog feedback current signal I_{FB}, the analog superposition node 24 configured to produce a difference signal I_DIFF as the difference between the DAC converted signal I_{ERR} and the analog feedback current signal I_{FB};
a (e.g., trans-resistance) analog-to-digital (briefly, ADC) circuit 26 coupled to the second superposition node 24 to receive therefrom the difference signal I_DIFF, the ADC circuit 26 configured to apply ADC conversion processing to the difference signal I_DIFF, providing a digital word signal W to user circuits as a result.

The arrangement exemplified in Figure 2 with respect to the arrangement exemplified in Figure 1 exploits DAC 22 to reduce the complexity of the ADC arrangement 26 without compromising accuracy.

For instance, applying signal processing to the digital input audio signal comprises:
producing 21 a digital error signal D_{ERR} indicative of a difference between the digital input audio signal and a digital word signal W;
applying digital-to-analog conversion, DAC 22 to the digital error signal D_{ERR}, producing an analog replica of the digital error signal I_{ERR} as a result;
producing 24 an analog difference signal I_{DIFF} indicative of a difference between the analog replica of the digital error signal and the analog feedback signal I_{FB};
applying analog-to-digital conversion, ADC 26 to the analog difference signal, producing the digital word signal as a result;
applying digital filtering 162; 562 to the digital word signal W, producing a filtered digital word signal D_{C} as a result; and
driving the switching converter circuit with the PWM signal produced based on the filtered digital word signal.

Still in the considered example, for instance:
the analog output signal comprises an output voltage signal;
the analog feedback signal indicative of the sensed analog voltage signal comprises a feedback current signal I_{FB} obtained as a ratio of the sensed analog voltage signal and a feedback resistive element R_{FB};
applying digital-to-analog, DAC conversion 22 to the digital error signal comprises converting the digital error signal D_{ERR} to an analog error current signal I_{ERR};
the analog difference signal indicative of the difference between the analog error current signal and the feedback current signal comprises a difference current signal (I_{DIFF}); and
the method comprises applying trans-resistance analog-to-digital, ADC conversion 26 to the difference current signal, producing the digital word signal as a result.

For instance, applying trans-resistance ADC conversion 260 to the difference current signal comprises applying sigma-delta processing, comprising:
integrating 261 the difference current signal, producing an integrated version thereof;
applying flash ADC conversion 264 to the integrated version of the difference current signal, producing a digital word W comprising a plurality of bits as a result.

As exemplified in Figure 2, the (e.g., trans-resistance) ADC circuit 26 comprises:
an input node E configured to receive the difference (e.g., current) signal I_{E} from the second superposition node 24;
an integrator stage 261, C_{F} comprising an (e.g., operational) amplifier 261 configured to receive the difference signal I_DIFF at an (e.g., inverting) input node and having a capacitive element C_{E} interposed the input node and an output node O of the amplifier 261, the integrator stage 261, C_{F} configured to provide an integrated (e.g., voltage) signal indicative of an integral over time of the difference (e.g., current) signal I_{DIFF},
a flash ADC circuit 264 coupled to the integrator stage 261, C_{F} to receive the integrated difference signal (such as a voltage signal) therefrom, the flash ADC 264 being based on the principle of comparing analog input voltage with a set of reference voltages (e.g., provided by a thermometric array not visible in Figure 2, in a manner per se known) to convert the analog input voltage into a digital signal of n-bit size (2ⁿ - 1), producing the digital word signal W as a result.

As exemplified in Figure 2, the trans-resistance ADC circuit 26 is configured to generate the digital word signal W to be a replica as close as possible to the value of the current intensity of the difference current I_{DIFF}.

In one or more alternative embodiments, the further feedback branch 29 may be configured to provide to the first superposition node 21 the digital word signal W directly from "inside" the flash ADC 264 as the feedback digital signal.

In such an alternative scenario, the digital word signal W is in a thermometric form while in the case in which the digital word signal is the output of the ADC 26, it is in binary form (e.g., a PWM modulated signal).

For the sake of simplicity, the integrator stage 261 exemplified in Figure 2 comprises a single pole. It is noted that such an arrangement is purely exemplary and in no way limiting, as the integrator stage 261 may comprise also a higher number of poles.

As exemplified herein, the gain of the integrator 261, C_{F} in the trans-resistance ADC 26 may be set to a maximum value within stability constraints in order to reduce the amplitude of the integrated signal, thereby increasing the performance of the flash ADC converter 264. For instance, the integrator 261 may comprise a variable gain amplifier, e.g., having a number of poles higher than one and a gain that may be increased in the range of frequencies of interest.

As exemplified in Figure 2, the DAC circuit 22 and flash ADC 264 of the (e.g., trans-resistance) ADC circuit 26 are temporally synchronized, for instance thanks to a clock signal CK having a same frequency (possibly with same or different phase) provided thereto by a clock signal generator circuit block (not visible in Figure 2), in a manner per se known.

Still in order to be able to control the performance of the trans-resistance ADC 260, it may be possible to vary, for instance:
frequency of the clock signal CK of sigma-delta modulator 26, and/or
the number of bits of the digital signals DRV, DTR produced by the flash ADC 264.

In the scenario exemplified in Figure 2, the precision of the sigma-delta modulator 26 is also based on the DAC converter 22.

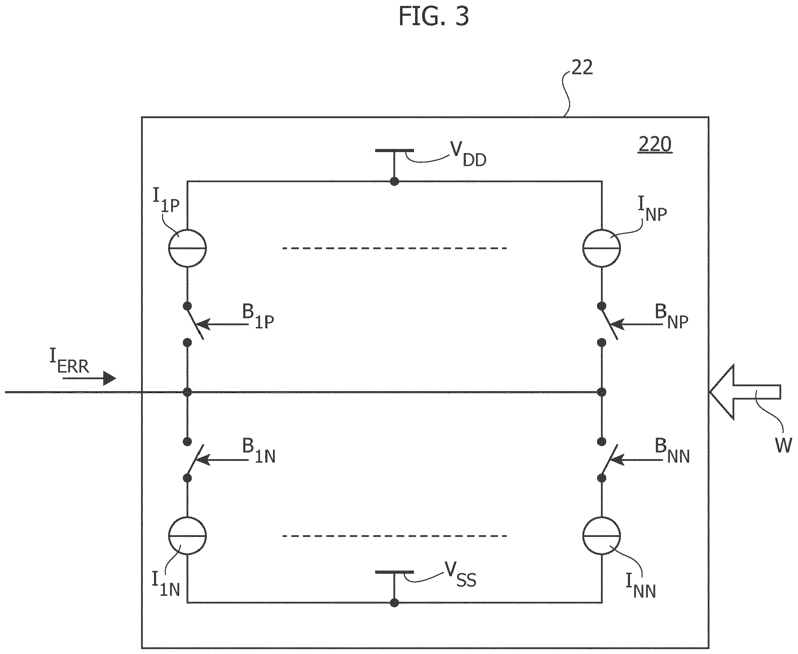

As exemplified in Figure 3, the DAC circuit 22 comprises a thermometric generator 220, optionally comprising a way of "scrambling" internal cells in order to reduce the impact of any mismatches therebetween.

As exemplified in Figure 3, the thermometric generator 220 in the DAC circuit 22 comprises:
a plurality of current generators I_{1P}, I_{NP}, I_{1N}, I_{NN} configured to provide respective electrical currents (e.g., a same fraction of a total current I_{ERR}) along a plurality of current lines between a positive supply line V_{DD} and a negative supply line V_{SS}; and
a plurality of switches B_{1P}, B_{NP}, B_{1N}, B_{NN} comprising switches matched to respective current generators in the plurality of current generators I_{1P}, I_{NP}, I_{1N}, I_{NN} wherein switches in the plurality of switches B_{1P}, B_{NP}, B_{1N}, B_{NN} are each configured to receive a bit of the digital word signal DRV, DTR provided by the flash ADC 264 and to be made conductive in response to the respective bit received having a first logic value (e.g., "1" or "true") and to be made non-conductive in response to the respective bit received having a second logic value (e.g., "0" or "false").

An arrangement as the one discussed in document US 7 239 258 B2 may be adapted for use in one or more embodiments.

For instance, in order to obtain an audio amplifier having an input dynamic range about 120 dB, the ADC circuit 260 may be designed to provide the same dynamic range.

For instance, dynamic range of about 100 dB may be adequate for the ADC 260.

As appreciable to those of skill in the art, the digital word signal W can correspond to a positive value or a negative value. Therefore, the digital error signal D_{ERR} can have a value lower than or greater than the value of the digital input signal D.

In order to produce a maximum output power, the audio amplifiers are designed so that the output voltage V_{OUT} is reached based on electric current intensity I_{IN} lower than maximum values.

As a result, the feedback current I_{F}B is also limited as it is a function of the output voltage V_{OUT}.

Therefore, the intensity of the error current I_{ERR} produced by the DAC circuit 22 is also limited to a current intensity value lower than the current intensity value encoded in the digital input signal D.

In the example considered herein, for instance, applying DAC conversion 22 comprises:
providing an array of current generators I_{1P}, I_{NP}, I_{1N}, I_{NN} arranged in a matrix and coupled therebetween via a corresponding set of switches B_{1P}, B_{NP}, B_{1N}, B_{NN} configured to be made conductive or non-conductive based on bits of a plurality of bits of the digital word signal W.

For instance, a superposition of currents generated by current generators in the array of current generators T_{1P}, I_{NP}, I_{1N}, I_{NN} and coupled therebetween via a subset of switches in the set of switches B_{1P}, B_{NP}, B_{1N}, B_{NN} made conductive based on the digital word signal W produces the analog error signal I_{ERR} whose current intensity value tends towards the current intensity value of an electrical current I of which the input digital input audio signal D is indicative.

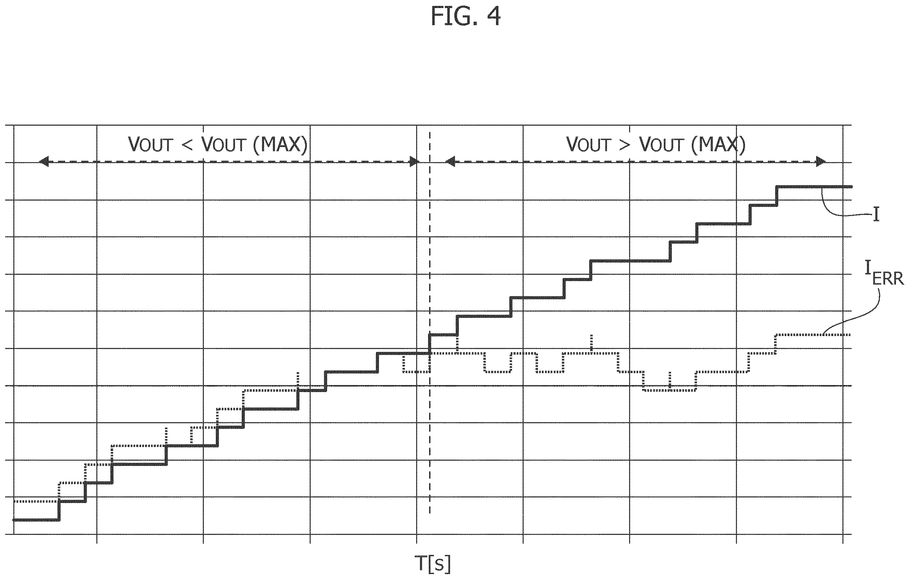

Figure 4 is exemplary of a relation between current intensity values of the input signal I and the DAC converted error signal I_{ERR} over time.

As exemplified in Figure 4, even when the input current intensity I encoded in the input digital signal D rises above a value that produced an output voltage V_{OUT} above the threshold voltage V_{OUT} (max), the current intensity of the DAC converted error signal I_{ERR} is clamped ad a lower level.

This may impact the number of current generators N, P present in the thermometric generator 220 in the DAC circuit 22, which can remain below or equal to 2 x m.

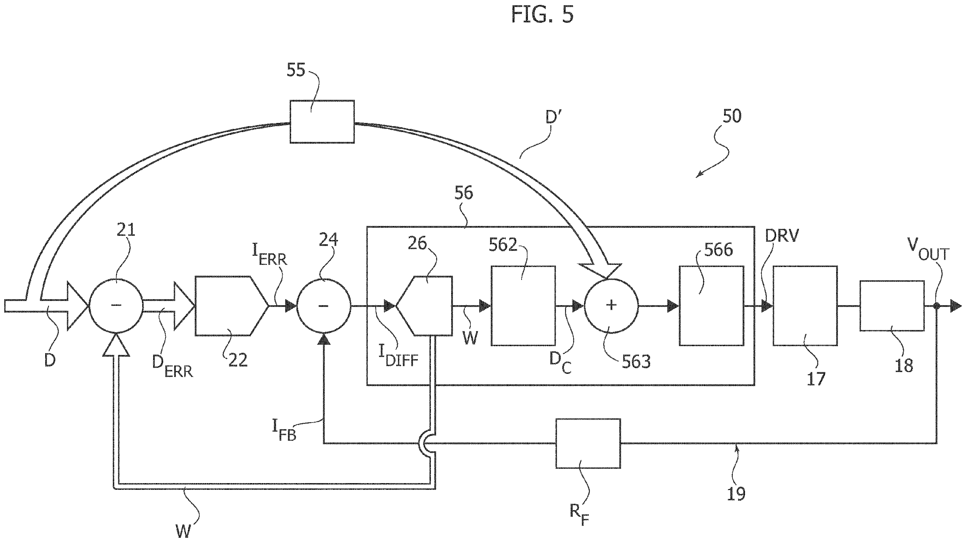

As exemplified in Figure 5, in an alternative scenario the audio amplification device 50 comprises:
a digital feedforward circuit block 55 configured to receive the digital input signal D and to apply a phase and amplitude correction thereto, producing a compensating digital signal D' as a result, and
an adder circuit block 563 interposed the digital filter circuit 562 and the digital PWM stage 566, the adder circuit block 563 coupled to the digital feedforward circuit block 55 and configured to receive the compensating digital signal D' therefrom to superimpose it to the digital signal provided by the digital filter circuit 562.

As exemplified in Figure 5, in case the range of values of the gain of the digital filter circuit 562, e.g., in the audio frequency range above 10kHz, cannot reach a suitable maximum value due to stability constraints, the digital signal W output by the ADC 26 may have a spurious signal component, e.g., sinusoidal, at the frequency of the signal superimposed thereon. Such a spurious component may be compensated thanks to the digital feedforward (briefly, FF) circuit block 55 of the device 50 exemplified in Figure 5.

As exemplified herein, the corresponding method comprises:
applying phase and magnitude correction 55 to the digital input signal, producing a compensating digital signal D' as a result;
adding 563 the compensating digital signal to the filtered digital error signal, and
producing the pulse-width-modulated, PWM, signal based on the sum of the filtered digital error signal and the compensating digital signal.

As exemplified in Figures 2 to 5, an audio amplification device 20; 50 comprises:
a digital input node configured to receive a digital input audio signal D;
a signal processing chain 21, 22, 24, 26 coupled to the digital input node to receive the digital input audio signal, the signal processing chain configured to provide an analog audio output signal V_{OUT} based on the digital input audio signal via a switching converter circuit 17 driven by a pulse-width-modulated, PWM, signal DRV;
a sensing circuit branch 19, R_{FB} coupled to the output node to sense the analog audio output signal V_{OUT} and configured to provide an analog feedback signal I_{FB} indicative of the sensed analog audio output signal.

For instance, the signal processing chain comprises:
a first superposition node 21 coupled to an analog-to-digital conversion, ADC circuit 26 to receive a digital word signal W and coupled to the input node to receive the digital input audio signal D, the first superposition node 21 configured to produce a digital error signal D_{ERR} indicative of a difference between the digital input audio signal and the digital word signal;
a digital-to-analog converter, DAC circuit 22 coupled to the first superposition node to receive the digital error signal, the DAC circuit configured to apply digital-to-analog conversion to the digital error signal, producing an analog replica of the digital error signal as a result;
a second superposition node 24 coupled to the sensing circuit branch 19, R_{F} to receive the analog feedback signal and coupled to the DAC circuit to receive the analog replica of the digital error signal, the second superposition node configured to produce an analog difference signal indicative of a difference between the analog replica of the digital error signal and the analog feedback signal;
an analog-to-digital converter, ADC circuit 26 coupled to the second superposition node to receive the analog difference signal and configured to apply analog-to-digital conversion 26 to the analog difference signal, producing said digital word signal as a result;
a digital filter circuit 162; 562 coupled to the ADC circuit to receive the digital word signal and configured to apply digital filtering to the digital word signal, producing a filtered digital word signal D_{C} as a result; and
a pulse-width-modulated, PWM, generator circuit 166; 566 coupled to the digital filter circuit to receive the filtered digital error signal, the PWM generator circuit configured to drive said switching converter circuit with the PWM signal produced based on the filtered digital word signal.

For instance:
the analog output signal at the output node comprises an output voltage signal;
the analog feedback signal indicative of the sensed analog voltage signal comprises a feedback current signal obtained as a ratio of the sensed analog voltage signal and a feedback resistive element R_{FB};
the DAC circuit is configured to apply digital-to-analog conversion to the digital error signal, converting the digital error signal to an error current signal;
the analog difference signal indicative of the difference between the error current signal and the feedback signal comprises a difference current signal, and
the ADC circuit is configured to apply trans-resistance analog-to-digital conversion to the difference current signal, producing the digital word signal as a result.

As exemplified in Figures 2 to 5, the ADC circuit configured to apply trans-resistance analog-to-digital conversion to the difference signal comprises sigma-delta processing circuitry, comprising:
a subtracting node E coupled to the second superposition node to receive the analog difference signal, the subtracting node configured to subtract a second difference signal from the difference signal;
an integrator circuit 261 coupled to the subtracting node, the integrator circuit configured to integrate the difference signal, producing an integrated version of the difference signal;
a flash ADC converter 264 coupled to the integrator circuit to receive the integrated version of the difference signal, the flash ADC converter configured to apply flash ADC conversion to the integrated version of the difference signal, producing a digital word W comprising a plurality of bits as a result.

As exemplified in Figures 2 to 5, the DAC circuit comprises:
an array of current generators I_{1P}, I_{NP}, I_{1N}, I_{NN} arranged in a matrix and coupled therebetween via a corresponding set of switches B_{1P}, B_{NP}, B_{1N}, B_{NN} configured to be made conductive or non-conductive based on bits in a plurality of bits of the digital word signal,
wherein a superposition of currents generated by current generators in the array of current generators I_{1P}, I_{NP}, I_{1N}, I_{NN} and coupled therebetween via a subset of switches in the set of switches made conductive based on the digital word signal produces the analog error signal whose current intensity value tends towards the current intensity value of an electrical current I of which the input digital input audio signal is indicative.

As exemplified in Figure 5, the audio amplification device 20; 50 comprises:
a feedforward circuit 55 coupled to the input node to receive the digital input audio signal, the feedforward circuit configured to apply phase and magnitude correction to the digital input signal, producing a compensating digital signal as a result;
an adder circuit 563 coupled to the digital filter circuit to receive the filtered digital word signal, the adder circuit configured to add the compensating digital signal to the filtered digital word signal, providing the resulting sum signal to the PWM generator circuit.

For instance, the PWM generator circuit 566 is configured to drive said switching converter circuit with the PWM signal produced based on the sum of the filtered digital word signal and the compensating digital signal.

As exemplified in Figures 1 to 5, the audio amplification device 20; 50 is coupled to at least one audio speaker 18 to provide thereto the output signal V_{OUT}, the audio amplifier configured to drive the at least one audio speaker to reproduce the audio signal received at the input node.

It will be otherwise understood that the various individual implementing options exemplified throughout the figures accompanying this description are not necessarily intended to be adopted in the same combinations exemplified in the figures. One or more embodiments may thus adopt these (otherwise non-mandatory) options individually and/or in different combinations with respect to the combination exemplified in the accompanying figures.

Without prejudice to the underlying principles, the details and embodiments may vary, even significantly, with respect to what has been described by way of example only, without departing from the extent of protection. The extent of protection is defined by the annexed claims.

## Claims

1. A method, comprising:
receiving a digital input audio signal (D);
applying signal processing (21, 22, 24, 26) to the digital input audio signal (D) received;
providing an analog audio output signal (V_{OUT}) based on the digital input audio signal (D) via a switching converter circuit (17) driven by a pulse-width-modulated, PWM, signal (DRV), and
sensing (19, R_{FB}) the analog audio output signal (V_{OUT}) and providing an analog feedback signal (I_{FB}) indicative of the sensed analog audio output signal (V_{OUT}),
wherein applying signal processing (21, 22, 24, 26) to the digital input audio signal (D) comprises:
producing (21) a digital error signal (D_{ERR}) indicative of a difference between the digital input audio signal (D) and a digital word signal (W);
applying digital-to-analog conversion, DAC (22) to the digital error signal (D_{ERR}), producing an analog replica of the digital error signal (I_{ERR}) as a result;
producing (24) an analog difference signal (I_{DIFF}) indicative of a difference between the analog replica of the digital error signal (I_{ERR}) and the analog feedback signal (I_{FB});
applying analog-to-digital conversion, ADC (26) to the analog difference signal (I_{DIFF}), producing said digital word signal (W) as a result;
applying digital filtering (162; 562) to the digital word signal (W), producing a filtered digital word signal (Dc) as a result; and
driving said switching converter circuit (17) with the PWM signal (DRV) produced based on the filtered digital word signal (Dc) .

2. The method of claim 1, wherein:
the analog output signal (V_{OUT}) comprises an output voltage signal;
the analog feedback signal (I_{FB}) indicative of the sensed analog voltage signal (V_{OUT}) comprises a feedback current signal (I_{FB}) obtained as a ratio of the sensed analog voltage signal and a feedback resistive element (RFB) ;
applying digital-to-analog, DAC conversion (22) to the digital error signal (D_{ERR}) comprises converting the digital error signal (D_{ERR}) to an analog error current signal (I_{ERR});
the analog difference signal (I_{DIFF}) indicative of the difference between the analog error current signal (I_{ERR}) and the feedback current signal (I_{FB}) comprises a difference current signal (I_{DIFF}); and
the method comprises applying trans-resistance analog-to-digital, ADC conversion (26) to the difference current signal (I_{DIFF}), producing the digital word signal (W) as a result.

3. The method of claim 2, wherein applying trans-resistance ADC conversion (260) to the difference current signal (I_{DIFF}) comprises applying sigma-delta processing to the difference current signal (I_{DIFF}), comprising:
integrating (261) the difference current signal, producing an integrated version thereof;
applying flash ADC conversion (264) to the integrated version of the difference current signal (I_{DIFF}), producing a digital word (W) comprising a plurality of bits as a result.

4. The method of any one of the previous claims, wherein applying DAC conversion (22) comprises:
providing an array of current generators (I_{1P}, I_{NP}, I_{1N}, I_{NN}) arranged in a matrix and coupled therebetween via a corresponding set of switches (B_{1P}, B_{NP}, B_{1N}, B_{NN}) configured to be made conductive or non-conductive based on bits of a plurality of bits of the digital word signal (W),
wherein a superposition of currents generated by current generators in the array of current generators (I_{1P}, I_{NP}, I_{1N}, I_{NN}) and coupled therebetween via a subset of switches in the set of switches (B_{1P}, B_{NP}, B_{1N}, B_{NN}) made conductive based on the digital word signal (W) produces the analog error signal (I_{ERR}) whose current intensity value tends towards the current intensity value of an electrical current (I) of which the input digital input audio signal (D) is indicative.

5. The method of any of the previous claims, comprising:
applying phase and magnitude correction (55) to the digital input audio signal (D), producing a compensating digital signal (D') as a result;
adding (563) the compensating digital signal (D') to the filtered digital error signal (D_{C}), and
producing (566) the pulse-width-modulated, PWM, signal (DRV) based on the sum of the filtered digital error signal (D_{C}) and the compensating digital signal (D').

6. The method of any one of the previous claims, comprising providing the output signal (V_{OUT}) to at least one audio speaker (18) and driving the at least one audio speaker (18) to reproduce the audio signal received.

7. An audio amplification device (20; 50), comprising:
a digital input node configured to receive a digital input audio signal (D);
a signal processing chain (21, 22, 24, 26) coupled to the digital input node to receive the digital input audio signal (D), the signal processing chain (21, 22, 24, 26) configured to provide an analog audio output signal (V_{OUT}) based on the digital input audio signal (D) via a switching converter circuit (17) driven by a pulse-width-modulated, PWM, signal (DRV);
a sensing circuit branch (19, R_{FB}) coupled to the output node to sense the analog audio output signal (V_{OUT}) and configured to provide an analog feedback signal (I_{FB}) indicative of the sensed analog audio output signal (V_{OUT});
wherein the signal processing chain (21, 22, 24, 26) comprises:
a first superposition node (21) coupled to an analog-to-digital conversion, ADC circuit (26) to receive a digital word signal (W) and coupled to the input node to receive the digital input audio signal (D), the first superposition node (21) configured to produce a digital error signal (D_{ERR}) indicative of a difference between the digital input audio signal (D) and the digital word signal (W);
a digital-to-analog converter, DAC circuit (22) coupled to the first superposition node (21) to receive the digital error signal (D_{ERR}), the DAC circuit (22) configured to apply digital-to-analog conversion to the digital error signal (D_{ERR}), producing an analog replica of the digital error signal (I_{ERR}) as a result;
a second superposition node (24) coupled to the sensing circuit branch (19, R_{F}) to receive the analog feedback signal (I_{FB}) and coupled to the DAC circuit (22) to receive the analog replica of the digital error signal (I_{ERR}), the second superposition node (24) configured to produce an analog difference signal (I_{DIFF}) indicative of a difference between the analog replica of the digital error signal (I_{ERR}) and the analog feedback signal (I_{FB});
an analog-to-digital converter, ADC circuit (26) coupled to the second superposition node (24) to receive the analog difference signal (I_{DIFF}) and configured to apply analog-to-digital conversion (26) to the analog difference signal (I_{DIFF}), producing said digital word signal (W) as a result;
a digital filter circuit (162; 562) coupled to the ADC circuit (26) to receive the digital word signal (W) and configured to apply digital filtering to the digital word signal (W), producing a filtered digital word signal (D_{C}) as a result; and
a pulse-width-modulated, PWM, generator circuit (166; 566) coupled to the digital filter circuit (162; 562) to receive the filtered digital error signal (D_{C}), the PWM generator circuit (166; 566) configured to drive said switching converter circuit (17) with the PWM signal (DRV) produced based on the filtered digital word signal (Dc) .

8. The audio amplification device (20; 50) of claim 7, wherein:
the analog output signal (V_{OUT}) at the output node comprises an output voltage signal (V_{OUT});
the analog feedback signal (I_{FB}) indicative of the sensed analog voltage signal (V_{OUT}) comprises a feedback current signal (I_{FB}) obtained as a ratio of the sensed analog voltage signal (V_{OUT}) and a feedback resistive element (R_{FB});
the DAC circuit (22) is configured to apply digital-to-analog conversion to the digital error signal (D_{ERR}), converting the digital error signal (D_{ERR}) to an error current signal (I_{ERR});
the analog difference signal (I_{DIFF}) indicative of the difference between the error current signal (I_{ERR}) and the feedback signal (I_{FB}) comprises a difference current signal, and
the ADC circuit (26) is configured to apply trans-resistance analog-to-digital conversion (26) to the difference current signal (I_{DIFF}), producing the digital word signal (W) as a result.

9. The audio amplification device (20; 50) of claim 7 or claim 8, wherein the ADC circuit (26) configured to apply trans-resistance analog-to-digital conversion to the difference signal (I_{DIFF}) comprises sigma-delta processing circuitry, comprising:
a subtracting node (E) coupled to the second superposition node (24) to receive the analog difference signal (I_{DIFF}), the subtracting node (E) configured to subtract a second difference signal from the difference signal (I_{DIFF});
an integrator circuit (261) coupled to the subtracting node (E), the integrator circuit (261) configured to integrate the difference signal (I_{DIFF}), producing an integrated version of the difference signal (I_{DIFF});
a flash ADC converter (264) coupled to the integrator circuit (261) to receive the integrated version of the difference signal (I_{DIFF}), the flash ADC converter (264) configured to apply flash ADC conversion to the integrated version of the difference signal (I_{E}), producing a digital word (W) comprising a plurality of bits as a result.

10. The audio amplification device (20; 50) of any of claims 7 to 9, wherein the DAC circuit (22) comprises:
an array of current generators (I_{1P}, I_{NP}, I_{1N}, I_{NN}) arranged in a matrix and coupled therebetween via a corresponding set of switches (B_{1P}, B_{NP}, B_{1N}, B_{NN}) configured to be made conductive or non-conductive based on bits in a plurality of bits of the digital word signal (W),
wherein a superposition of currents generated by current generators in the array of current generators (I_{1P}, I_{NP}, I_{1N}, I_{NN}) and coupled therebetween via a subset of switches in the set of switches (B_{1P}, B_{NP}, B_{1N}, B_{NN}) made conductive based on the digital word signal (W) produces the analog error signal (I_{ERR}) whose current intensity value tends towards the current intensity value of an electrical current (I) of which the input digital input audio signal (D) is indicative.

11. The audio amplification device (20; 50) of any of claims 7 to 10, comprising:
a feedforward circuit (55) coupled to the input node to receive the digital input audio signal (D), the feedforward circuit (55) configured to apply phase and magnitude correction (55) to the digital input signal (D), producing a compensating digital signal (D') as a result;
an adder circuit (563) coupled to the digital filter circuit (562) to receive the filtered digital word signal (D_{C}), the adder circuit (563) configured to add the compensating digital signal (D') to the filtered digital word signal (D_{C}), providing the resulting sum signal to the PWM generator circuit (566),
wherein the PWM generator circuit (566) is configured to drive said switching converter circuit (17) with the PWM signal (DRV) produced based on the sum of the filtered digital word signal (D_{C}) and the compensating digital signal (D').

12. The audio amplification device (20; 50) of any one of claims 7 to 11, coupled to at least one audio speaker (18) to provide thereto the output signal (V_{OUT}), the audio amplifier configured to drive the at least one audio speaker (18) to reproduce the audio signal received at the input node.
